# EUROPEAN PATENT SPECIFICATION

(11) **EP 0 777 912 B1**
(45) Date of publication and mention of the grant of the patent: **18.11.1998**
(21) Application number: 95930778.6
(22) Date of filing: 01.09.1995
(51) Int. Cl.: H01L 41/00, G08B 13/22

(54) **A TRANSDUCER ELEMENT**
WANDLERANORDNUNG
ELEMENT TRANSDUCTEUR

(30) Priority: 02.09.1994 SE 9402944
(43) Date of publication of application: 11.06.1997
(73) Proprietor: RSO CORPORATION N.V., Curaçao (AN)
(72) Inventor: CLARK, Arthur, E., Adelphi, MD 20783 (US); TYREN, Carl, F-06600 Antibes (FR)
(74) Representative: Ström, Tore
(86) International application number: SE9500983
(87) International publication number: WO9608046

(56) References cited:
- WO-A-88/09979
- US-A- 4 510 490
- US-A- 4 727 360

## Description

The present invention relates to transducer elements, i.e. elements being able to transform various forms of mechanical energy to electrical energy, or vice versa. Such elements are being used in a variety of applications as measuring elements, control elements, signal elements, detection elements, etc.

Elements of the kind mentioned above are often formed as thin wires, strips, or ribbons with a small material thickness. This is for instance particularly true in the case of amorphous elements with a high magneto-mechanical coupling. Since the manufacturing process requires an extraordinarily fast cooling of the manufactured amorphous foil or ribbon, the thickness of the foil, ribbon or strip is very small, for instance in the order of 25µm.

The use of such thin elements may cause problems in certain applications. One example is the use of thin amorphous elements with a high magneto-mechanical coupling in detection labels. The label and the thin strip-shaped elements enclosed in the label are exposed to a magnetic interference signal forcing the strips into a state of mechanical self-oscillation. By means of a detection coil the strip resonance frequency may be detected. In the detection step a longitudinal mode of oscillation is therefore detected. If during the detection said amorphous strips are allowed to bend or to be exposed to a bending force, for instance through influence from gravity, the energy of the self-oscillation is fully or partly transferred from a longitudinal mode of oscillation to a bending mode of oscillation, thereby making the intended detection much more difficult or completely impossible. These conditions lead to substantial problems with regard to the mounting of the amorphous strips inside the label. First, the strips must be mounted in the label in such a way, that their freedom of movement is not limited and that the longitudinal oscillation is not restricted, and second, the strips should be suspended in such a way, that the strips are not exposed to a bending force during the detection. The problem is accentuated by the fact that the material thickness of the amorphous strips is very small.

The present invention relates to a transducer element, i.e. an element being able to transform various forms of mechanical energy to electrical energy or vice versa, the transducer element being given such a form that the difficulties mentioned above are removed or reduced to a great extent, and that the application or mounting of the elements are substantially facilitated, the element properties adapted to the intended use being preserved.

The objects mentioned above are achieved by providing the transducer element with the features mentioned in the appended patent claims.

The invention will now be described with reference to one embodiment illustrated in the enclosed drawing. In the drawing
FIG. 1 is an enlarged perspective view of a transducer element according to the invention,
FIG. 2 is a cross-sectional view according to arrows A-A in FIG. 1,
FIG. 3 is a perspective view of an embodiment according to the invention, and
FIG. 4 is a cross-sectional view according to arrows B-B in FIG. 3.

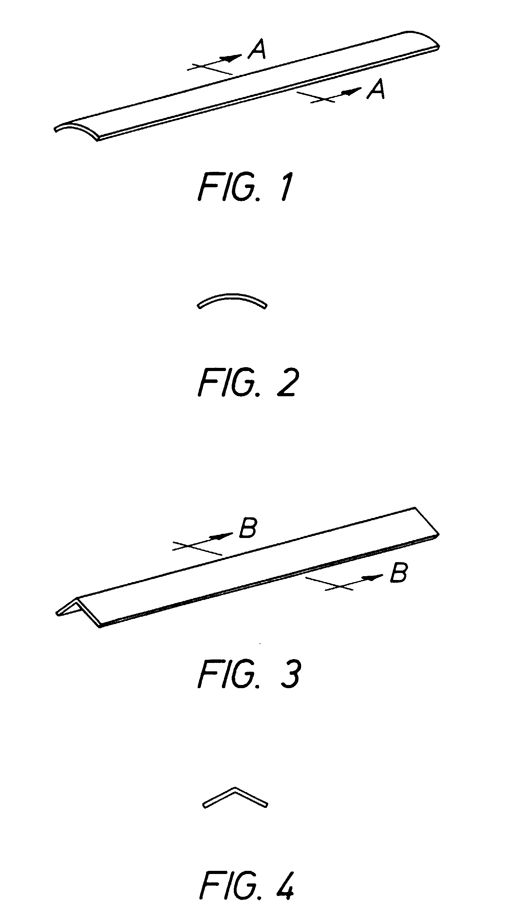

For exemplifying and non-limiting reasons FIGS. 1-4 show transducer elements of the kind being used for instance as detection elements in labels, said elements being constituted by thin strips or ribbons of an amorphous magneto-elastical material. The length of the strips is for instance about 50 mm, the width is 1 or 2 mm, and the thickness is about 25 µm. According to the invention the strips or ribbons are provided with a cross section, the shape of which deviates from a planar cross-sectional shape. The element shown in FIG. 1 thus has an arched cross-sectional shape, which appears more clearly from FIG. 2. The cross section of the element according to FIG. 3 is angularly shaped, as appears from FIG. 4. However, other cross-sectional shapes are possible, for instance a right-angled, L-shaped, U-shaped, T-shaped, S-shaped form, or the like. A common fact for all the cross sections mentioned above is that the cross-sectional shape deviating from a planar cross-sectional shape provides the per se thin element with a substantially increased bending stiffness, the element thereby maintaining its straightness despite the influence from forces or loads normally exerted in the detection zone on the label, in which one or more elements according to the invention are contained. Apart from increasing the bending stiffness of the element, the cross-sectional shapes mentioned above also increase the torsional stiffness of the element.

An advantage achieved by the element design described above is that the enclosure of the element in a cavity, for instance in a label, is facilitated. The element may be supported at its center, and in such a case the element protrudes from both sides of the bearing point with a maintained straightness. As an alternative the element may be supported at its respective ends, the element thereby extending rectilinearly with no bending between the bearing points, despite the influence from external forces normally exerted on the element. Consequently, the element according to the invention enables degree of freedom with regard to the element enclosure, for instance in a label, and hence it is possible to reduce the free height in the cavity, in which the element(s) will be arranged. When the element according to the invention is enclosed in a label, the element consequently facilitates a reduction of the label thickness.

A second, very important advantage of the element design according to the invention is that this design facilitates elimination of an undesired coupling between a longitudinal mode of oscillation and a bending mode of oscillation. Consequently, the element according to the invention facilitates a change of undesired transfer modes and "locking" to a desired transfer mode. In comparison with previously known transducer elements the element according to the invention has a substantially altered coupling matrix.

The invention has been described above according to an example, where the element is made from an amorphous magneto-elastical material; however, the invention is not limited to such elements of amorphous material, but may generally be applied to thin transducer elements of magneto-elastical or piezo-electrical materials within the scope of the appended patent claims.

## Claims

1. A transducer element for transforming mechanical energy to electrical energy or vice versa, comprising an elongated thin strip or ribbon of an magneto-elastical or piezo-electrical material, **characterized** in that the element is provided with a cross-sectional shape deviating from a planar cross-sectional shape.

2. A transducer element according to claim 1, **characterized** in that the element is provided with a cross-sectional shape forming a portion of a circle.

3. A transducer element according to claim 1, **characterized** in that the element has an angular cross-section.

4. A transducer element according to claim 1, **characterized** in that the element has a right-angled cross section.

5. A transducer element according to claim 1, **characterized** in that the element has an L-shaped cross section.

6. A transducer element according to claim 1, **characterized** in that the element has an U-shaped cross section.

7. A transducer element according to claim 1, **characterized** in that the element has a T-shaped cross section.

8. A transducer element according to claim 1, **characterized** in that the element has an S-shaped cross-section.

9. A transducer element according to any preceding claim, **characterized** in that the element is constituted by a thin strip or ribbon of an amorphous magneto-elastical material with a high magneto-mechanical coupling.

## Patentansprüche

1. Wandlerelement zum Umwandeln mechanischer Energie in elektrische Energie und umgekehrt, mit einem länglichen, dünnen Streifen oder Band aus einem magnetoelastischen oder piezoelektrischen Material, **dadurch gekennzeichnet**, daß das Element eine von einer ebenen Querschnittsform abweichende Querschnittsform besitzt.

2. Wandlerelement nach Anspruch 1, **dadurch gekennzeichnet**, daß das Element mit einer einen Kreisabschnitt bildenden Querschnittsform versehen ist.

3. Wandlerelement nach Anspruch 1, **dadurch gekennzeichnet**, daß das Element einen angewinkelten Querschnitt besitzt.

4. Wandlerelement nach Anspruch 1, **dadurch gekennzeichnet**, daß das Element einen rechtwinkligen Querschnitt besitzt.

5. Wandlerelement nach Anspruch 1, **dadurch gekennzeichnet**, daß das Element einen L-förmigen Querschnitt besitzt.

6. Wandlerelement nach Anspruch 1, **dadurch gekennzeichnet**, daß das Element einen U-förmigen Querschnitt besitzt.

7. Wandlerelement nach Anspruch 1 **dadurch gekennzeichnet**, daß das Element einen T-förmigen Querschnitt besitzt.

8. Wandlerelement nach Anspruch 1, **dadurch gekennzeichnet** daß das Element einen S-förmigen Querschnitt besitzt.

9. Wandlerelement nach irgendeinem vorangehenden Anspruch, **dadurch gekennzeichnet**, daß das Element durch einen dünnen Streifen oder ein dünnes Band aus einem amorphen magnetoelastischen Material mit hoher magnetomechanischer Kopplung gebildet ist.

## Revendications

1. Elément transducteur pour transformer l'énergie mécanique en énergie électrique ou vice-versa, comprenant une bande ou ruban mince allongé(e) en matériau magnéto-élastique ou piézoélectrique, caractérisé en ce que l'élément est pourvu d'une forme de section transversale différente d'une forme de section transversale planaire.

2. Elément transducteur selon la revendication 1, caractérisé en ce que l'élément est pourvu d'une forme de section transversale formant une partie d'un cercle.

3. Elément transducteur selon la revendication 1, caractérisé en ce que l'élément présente une section transversale angulaire.

4. Elément transducteur selon la revendication 1, caractérisé en ce que l'élément présente une section transversale en angle droit.

5. Elément transducteur selon la revendication 1, caractérisé en ce que l'élément présente une section transversale en forme de L.

6. Elément transducteur selon la revendication 1, caractérisé en ce que l'élément présente une section transversale en forme de U.

7. Elément transducteur selon la revendication 1, caractérisé en ce que l'élément présente une section transversale en forme de T.

8. Elément transducteur selon la revendication 1, caractérisé en ce que l'élément présente une section transversale en forme de S.

9. Elément transducteur selon l'une quelconque des revendications précédentes, caractérisé en ce que l'élément est constitué d'une bande, ou ruban mince, en matériau magnéto-élastique amorphe, ayant un couplage magnéto-mécanique élevé.
